# FASCICULE DE BREVET EUROPEEN

(11) **EP 2 836 332 B1**
(45) Date de publication et mention de la délivrance du brevet: **28.12.2016**
(21) Numéro de dépôt: 13723418.3
(22) Date de dépôt: 12.04.2013
(51) Int. Cl.: B23K 26/38, B23K 26/06, B23K 26/40

(54) **DISPOSITIF ET METHODE DE NANO-USINAGE PAR LASER**
VORRICHTUNG UNS VERFAHREN ZUR NANOSKALIGEN LASERBEARBEITUNG
DEVICE AND METHOD FOR NANO-SCALE LASER MACHINING

(30) Priorité: 13.04.2012 FR 1253404
(43) Date de publication de la demande: 18.02.2015
(73) Titulaire: Centre National de la Recherche Scientifique (C.N.R.S.), 75794 Paris Cedex 16 (FR); Université de Franche-Comté, 25000 Besançon (FR)
(72) Inventeur: COURVOISIER, François, 25870 Cussey-sur-l'Ognon (FR); LACOURT, Pierre-Ambroise, 25000 Besançon (FR); JACQUOT, Maxime, 25000 Besançon (FR); FURFARO, Luca, 25780 Auxon Dessus (FR); DUDLEY, John, 25000 Besançon (FR); DE LABACHELERIE, Michel, 25410 Ferrieres-les-Bois (FR)
(74) Mandataire: Osha Liang
(86) Numéro de dépôt international: PCT/EP2013/057673
(87) Numéro de publication internationale: WO 2013/153195

(56) Documents cités:
- WO-A2-2009/114375
- JP-A- 2010 247 230
- US-A1- 2007 051 706
- BHUYAN M ET AL: "High aspect ratio nanochannel machining using single shot femtosecond Bessel beams", APPLIED PHYSICS LETTERS, AIP, AMERICAN INSTITUTE OF PHYSICS, MELVILLE, NY, US, vol. 97, no. 8, 23 août 2010 (2010-08-23), pages 81102-81102, XP012138874, ISSN: 0003-6951, DOI: 10.1063/1.3479419 cité dans la demande

## Description

### Domaine technique de l'invention

La présente invention concerne une méthode et un dispositif de nano-usinage par laser, adapté notamment au nano-perçage à grand rapport de forme ou à la soudure.

### Etat de l'art

Dans le contexte par exemple du perçage de canaux ou « vias » dans ou à travers des wafers de semi-conducteurs pour la micro et la nanoélectronique et le photovoltaïque, on cherche à obtenir des perçages profonds, c'est-à-dire à grand rapport de forme, le rapport de forme étant défini par le rapport longueur sur diamètre du trou percé. Le perçage profond est cependant extrêmement difficile à obtenir quelle que soit la technique utilisée. En effet, l'extraction de la matière et l'apport d'énergie dans un trou d'un diamètre beaucoup plus petit que sa profondeur sont des points bloquants. Ces techniques de perçage comprennent par exemple la focalisation de faisceaux d'ions (procédé dit « ebeam ») ou la photolithographie suivie d'attaque chimique (ou RIE selon l'expression anglo-saxonne « reactive ionic etching »). La technologie ebeam nécessite un besoin de vide poussé, est adaptée à des trous de diamètres inférieurs à 100 nm, présente une lenteur du perçage et les rapports de forme des trous de perçage obtenus sont limités à des rapports de l'ordre de 10 à 50. La technologie de photolithographie nécessite la réalisation préalable d'un masque ; elle est donc peu souple et coûteuse. Les rapports de forme obtenus sont de l'ordre de 10.

Dans le domaine de la micro/nano structuration à haut rapport de forme de matériaux diélectriques (verre), les inventeurs ont montré que l'utilisation d'un faisceau laser femtoseconde avec un profil spatial "non-diffractant" du type faisceau de Bessel, donne accès au contrôle du dépôt d'énergie dans la profondeur du matériau. Cette technologie permet notamment de réaliser une micro-explosion suffisamment intense et localisée pour évacuer le matériau à ablater (voir par exemple M.K. Bhuyan et al., « High aspect ratio nanochannel machining using single shot femtosecond Bessel beams », Appl. Phys. Lett. 97, 081102 (2010)). Ainsi, une seule impulsion laser permet de créer un nano-trou de très haut rapport de forme (nano-canal).

Cependant, cette technique n'est pas applicable au nano-usinage dans les matériaux semi-conducteurs. D'une part ces matériaux sont opaques aux longueurs d'ondes usuelles des lasers de puissance pour l'usinage (UV, visible et proche infrarouge) et les faisceaux laser ne peuvent donc pas s'y propager. D'autre part, les matériaux semi-conducteurs sont fortement non linéaires, et la propagation de faisceaux non diffractant aux intensités lumineuses requises pour l'ablation entraînerait une oscillation de l'intensité le long de l'axe de propagation due aux effets non linéaires de type Kerr, résultant dans un dépôt inhomogène de l'énergie le long de l'axe de propagation et des qualités de perçage amoindries.

Par ailleurs, dans les matériaux diélectriques comme le verre, les déposants ont mis en évidence des effets de déstabilisation du faisceau non diffractant lors de l'ablation de la face d'entrée, dus notamment à des contrastes d'indices non linéaires entre l'air et le verre, résultant là encore dans une inhomogénéité du dépôt d'énergie le long de l'axe de propagation.

Un objet de l'invention est de proposer un dispositif et une méthode de nano-usinage, notamment pour le perçage à haut rapport de forme, applicable au nano-usinage dans les matériaux diélectriques comme dans les matériaux semi-conducteurs.

### RESUME DE L'INVENTION

Selon un premier aspect, l'invention concerne un dispositif de nano-usinage par laser d'un échantillon en matériau présentant une bande de transparence donnée, le dispositif comprenant :
- un module de focalisation permettant de générer à partir d'un faisceau incident donné un faisceau non diffractant selon une ligne de focalisation généralement orientée selon l'axe optique du module de focalisation;
- des premiers moyens d'émission d'une première impulsion lumineuse de bande spectrale comprise dans la bande de transparence dudit matériau, apte à générer dans ledit matériau, après focalisation par ledit module de focalisation, un plasma de charges libres au niveau de ladite ligne de focalisation par absorption multi-photonique formant ainsi un « canal plasma »;
- des seconds moyens d'émission d'au moins une seconde onde électromagnétique de bande spectrale comprise dans la bande de transparence dudit matériau, destinée à être superposée spatialement audit canal plasma pour générer un échauffement dudit matériau par absorption par les charges libres du plasma.

Les déposants ont montré qu'un tel dispositif permet le nano perçage à haut rapport de forme dans tout type de matériau présentant une bande spectrale de transparence aux ondes lumineuses, y compris les matériaux semi-conducteurs. En effet, on limite grâce à une mise en forme temporelle des impulsions incidentes dans l'échantillon les effets non linéaires et notamment les effets Kerr responsables d'inhomogénéité dans la formation du canal plasma.

Ainsi la première impulsion lumineuse ultra brève, par exemple de durée inférieure à 10 picosecondes, permet, après focalisation dans l'échantillon au moyen du module de focalisation, la formation du plasma de charges libres par absorption multi-photonique. La ou les secondes onde(s) électromagnétique(s) dont l'intensité lumineuse est inférieure à celle de la première impulsion, permettent de déposer l'énergie par absorption par les charges libres du plasma.

Les faisceaux non diffractant sont avantageusement des faisceaux de type faisceau de Bessel ou faisceau d'Airy.

Selon une variante, la ou lesdites secondes ondes électromagnétiques peuvent être des ondes micro-ondes ou térahertz, la longueur d'onde de ces ondes étant comprise dans le domaine de transparence du matériau que l'on cherche à usiner afin d'éviter toute absorption linéaire.

Alternativement, la ou lesdites secondes ondes électromagnétiques sont des ondes lumineuses de longueur d'onde également comprise dans le domaine de transparence du matériau.

Dans ce dernier cas, selon une variante, les seconds moyens d'émission permettent l'émission d'une seconde impulsion lumineuse unique, par exemple de durée comprise entre quelques fractions de picosecondes et quelques millisecondes. Alternativement, les seconds moyens d'émission peuvent permettre l'émission d'un train d'impulsions, par exemple des impulsions brèves, rapprochées temporellement.

Pour la formation desdites première et seconde(s) impulsions lumineuses, il est possible d'utiliser selon une variante deux sources laser distinctes synchronisées.

Alternativement, lesdits premier et second moyens d'émission sont formés par une source d'émission d'une impulsion laser unique et comprennent un module de mise en forme temporelle permettant de générer à partir de l'onde lumineuse émise par ladite source laser les première et seconde(s) impulsions lumineuses.

Par exemple, le module de mise en forme temporelle comprend un séparateur de faisceaux permettant de former au moins deux voies, et sur au moins l'une des voies, un étireur d'impulsion.

Selon un autre exemple, le module de mise en forme temporelle comprend un système acousto-optique de type DAZZLER®.

Selon une variante, le dispositif selon le premier aspect comprend en outre un module de conversion de fréquence en aval dudit module de mise en forme temporelle. Ce module de conversion de fréquence permet d'adapter la longueur d'onde de la source d'émission laser à la bande de transparence du matériau à usiner, notamment dans le cas de matériaux de type semi-conducteur.

Avantageusement, le dispositif selon le premier aspect comprend en outre un module de balayage permettant le mouvement relatif entre le faisceau non diffractant et l'échantillon.

Selon une variante, le module de focalisation permet la génération de plusieurs faisceaux non diffractant en parallèle pour former un ensemble de lignes de focalisation dans l'échantillon.

Selon un second aspect, l'invention concerne une méthode de nano-usinage laser d'un échantillon en matériau présentant une bande de transparence donnée, la méthode comprenant :
- l'émission d'une première impulsion de bande spectrale comprise dans la bande de transparence dudit matériau;
- la mise en forme spatiale de ladite première impulsion permettant de former après focalisation dans ledit échantillon un faisceau non diffractant selon une ligne de focalisation, l'intensité lumineuse dudit faisceau non diffractant permettant de générer un plasma de charges libres au niveau de ladite ligne de focalisation par absorption multi-photonique, formant ainsi un « canal plasma »;
- l'émission d'au moins une seconde onde électromagnétique de bande spectrale comprise dans la bande de transparence dudit matériau, superposée spatialement audit canal plasma pour générer un échauffement dudit matériau par absorption par les charges libres du plasma.

Selon une variante, la mise en forme spatiale de ladite première impulsion comprend en outre une modulation spatiale de l'amplitude de ladite impulsion afin de rendre l'intensité lumineuse de ladite première impulsion sensiblement constante sur ladite ligne de localisation.

Selon un premier exemple, la méthode selon le second aspect est appliquée au nano-perçage d'un échantillon en matériau donné pour la formation d'un canal, et comprend en outre :
- le contrôle de la position et de la longueur du canal à percer par la mise en forme spatiale et l'intensité lumineuse de ladite première impulsion lumineuse et
- le contrôle du diamètre du canal par l'énergie déposée par la ou lesdite(s) seconde(s) onde(s) électromagnétique(s) au niveau du canal plasma ainsi formé.

Selon un second exemple, la méthode selon le second aspect est appliquée à la soudure entre un premier échantillon et un second échantillon, et comprend en outre :
- le contrôle de la position et de la longueur du canal d'échauffement à l'interface des deux échantillons par la mise en forme spatiale et l'intensité lumineuse de ladite première impulsion lumineuse et
- le contrôle de la température de fusion à ladite interface par l'énergie déposée par ladite seconde onde électromagnétique au niveau du canal plasma ainsi formé.

Avantageusement, la méthode selon le second aspect est utilisée pour le nano-usinage d'un échantillon en matériau semi-conducteur, par exemple au nano perçage de canaux dans des échantillons en matériau semi-conducteur ou à la soudure entre deux échantillons dont au moins l'un est en matériau semi-conducteur. Par matériau semi-conducteur, on entend dans la présente description un matériau dont la bande de valence et la bande de conduction sont disjointes énergétiquement (présence d'un « gap ») et dont la bande de conduction est vide ou quasiment vide à température ambiante. Par exemple, il peut s'agir d'un matériau choisi parmi le silicium, le germanium, le carbure de silicium (SiC), le silicium-germanium (SiGe), un matériau appartenant à la famille des arséniures de gallium-aluminium (AlₓGa₁₋ₓAs), arséniures de gallium-indium (InₓGa₁₋ₓAs), Phosphure de gallilum-indium (InGaP), oxyde de zinc (ZnO), sulfure de zinc (ZnS), Tellurure de zinc (ZnTe), etc.

La méthode décrite dans la présente demande s'applique également aux matériaux diélectriques, par exemple les verres, la silice fondue, le quartz, le niobate de lithium, le diamant.

### BREVE DESCRIPTION DES DESSINS

D'autres avantages et caractéristiques de l'invention apparaîtront à la lecture de la description, illustrée par les figures suivantes :
- Figure 1, un schéma illustrant selon un exemple la méthode de nano-usinage selon l'invention ;
- Figure 2, un schéma montrant un exemple de module de mise en forme spatiale d'un dispositif selon l'invention ;
- Figure 3, un schéma illustrant la focalisation d'un faisceau non diffractant, de type faisceau de Bessel ;
- Les figures 4A à 4D, des images et des profils spatiaux de l'intensité, montrant des exemples de faisceaux de Bessel obtenus expérimentalement, selon un profil longitudinal (4A, 4B) et un profil transverse (4C, 4D);
- La figure 5, une simulation montrant la cartographie dans le plan de la densité de plasma obtenue dans un matériau diélectrique de type verre, avec un dispositif de l'art antérieur ;
- La figure 6, une simulation montrant la cartographie dans le plan de la densité de plasma obtenue dans un matériau diélectrique de type verre, avec un dispositif selon un exemple de réalisation de l'invention ;
- Les figures 7A et 7B, deux exemples de réalisation de dispositifs selon l'invention ;
- Les figures 8A à 8D, des exemples de mis en oeuvre de la méthode de nano-usinage selon l'invention appliqués au perçage, traversant ou non, et à la soudure;
- La figure 9A, un schéma montrant l'application de la méthode de nano-usinage avec un faisceau d'Airy et la figure 9B, une image montrant la répartition d'intensité d'un faisceau d'Airy.

### DESCRIPTION DETAILLEE

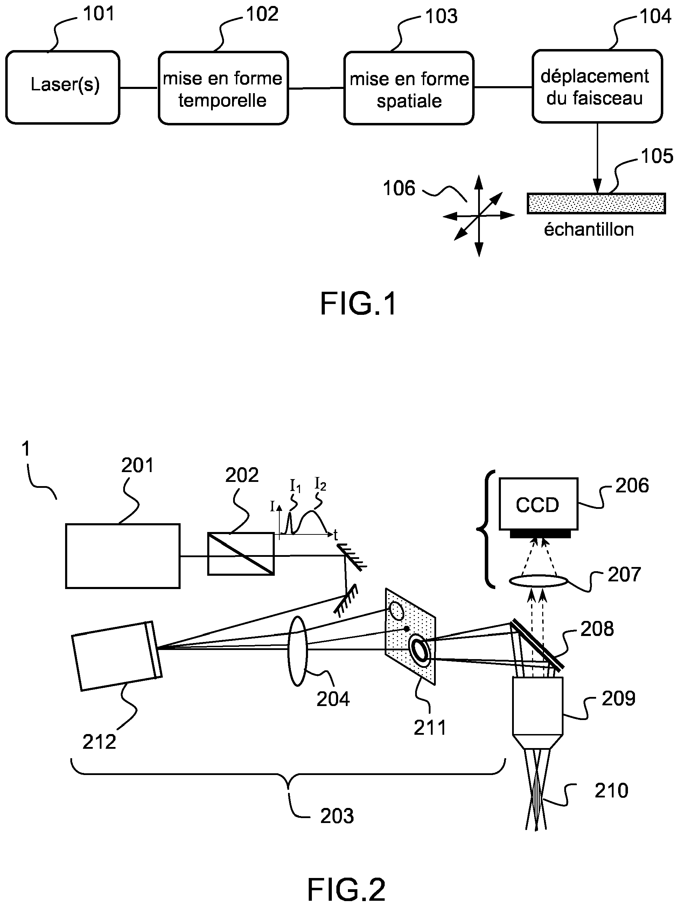

La figure 1 illustre par un schéma la méthode de nano-usinage selon un exemple de réalisation de l'invention.

Selon cet exemple, la méthode de nano-usinage comprend l'émission 101 d'un faisceau par une source laser impulsionnelle, et la focalisation du faisceau sur un échantillon 105 à percer, après une étape de mise en forme temporelle 102 et une étape de mise en forme spatiale 103, qui seront décrites plus en détail ci-dessous. Le balayage 104 du faisceau et la translation/rotation (symbolisé par les flèches 106) de l'échantillon peuvent permettre de réaliser un mouvement relatif entre le faisceau et l'échantillon pour réaliser séquentiellement plusieurs perçages sur un même échantillon.

La mise en forme temporelle 102 comprend dans cet exemple la génération à partir d'une source laser unique d'une première et d'une seconde impulsions lumineuses de bande spectrale comprise dans une bande de transparence du matériau dont est formé l'échantillon. La bande de transparence du matériau est le domaine spectral dans lequel le coefficient d'absorption du milieu est inférieur à une valeur donnée, par exemple 0,5 cm⁻¹, correspondant à une transmission du milieu supérieure à 60% pour un milieu d'épaisseur 1 cm. La bande spectrale de transparence est ainsi par exemple la bande spectrale au-delà de 1100 nm pour un échantillon en matériau semi-conducteur de type silicium. Autrement dit, les bandes spectrales des première et seconde impulsions sont choisies afin que la transition électronique ne puisse être réalisée que par une transition optique à au moins deux photons. La première impulsion est de courte durée, par exemple inférieure à 10 picosecondes, de préférence de l'ordre de quelques fractions de picosecondes. La deuxième impulsion, plus longue, voire continue, permet d'exciter ces électrons et déposer la majeure partie de l'énergie permettant l'ablation laser. La deuxième impulsion peut être synchronisée avec la première afin de permettre que l'excitation produite par la première impulsion soit encore active au moment de l'arrivée de la deuxième impulsion (typiquement, cette excitation dure entre 0.1 et 5 picosecondes, selon les matériaux). La deuxième impulsion dans le cas où son intensité est suffisante, peut aussi amplifier l'effet de densité de plasma par effet d'avalanche d'ionisation. Cependant, l'intensité de l'une et de l'autre des deux impulsions doit être limitée pour ne pas générer d'instabilité de propagation due à des effets non linéaires de type Kerr.

Alternativement, deux sources laser distinctes peuvent être utilisées pour générer les première et seconde impulsions.

La mise en forme spatiale 103 du faisceau incident permet de former après focalisation un faisceau non diffractant formant une ligne de focalisation dans l'échantillon. Le faisceau non diffractant est par exemple un faisceau de Bessel ou un faisceau d'Airy, ou plus généralement un faisceau possédant la propriété de garder un profil constant le long de l'axe de propagation sur une ligne de focalisation de dimension donnée, d'où le nom de « non diffractant ». Cette mise en forme spatiale est appliquée à la première impulsion de courte durée, et possiblement aussi à la seconde impulsion comme cela sera décrit par la suite. Il apparaît que lorsque la durée d'impulsion est courte (typiquement inférieure à quelques fractions de picosecondes), la propagation non linéaire du faisceau peut être stabilisée à haute intensité en augmentant la focalisation, c'est-à-dire en diminuant la taille de la tache lumineuse de plus haute intensité dans la section transverse du faisceau. Cependant, si les effets non-linéaires (effet Kerr en particulier) sont très importants, la stabilisation des faisceaux requiert d'utiliser de très fortes focalisations (angles typiquement supérieurs à 20°). Il n'est alors plus techniquement réalisable de produire des faisceaux non-diffractant, par exemple des faisceaux de type Bessel, très longs et très focalisés, car ceci nécessiterait des optiques de très grand diamètre, coûteuses, encombrantes et difficiles à aligner.

La mise en forme temporelle du faisceau incident sous la forme de deux impulsions de durées et de longueur d'onde appropriées permet de réaliser une excitation à faible énergie et de minimiser de ce fait les effets non-linéaires lors de la propagation dans le matériau, puis de déposer la densité d'énergie nécessaire à l'échauffement du matériau pour l'ablation ou la soudure grâce à la deuxième impulsion de durée plus longue. Alternativement, le dépôt de l'énergie peut se faire au moyen d'une onde électromagnétique qui n'est pas une onde lumineuse, par exemple une onde de type micro-onde ou térahertz, tant que la bande spectrale de l'onde électromagnétique est comprise dans le domaine de transparence du matériau et peut être absorbée par les charges libres du plasma formé par la première impulsion. Alternativement, le dépôt d'énergie peut se faire par un train d'impulsions courtes et rapprochées, comme cela sera détaillé dans la suite de la description.

Ainsi, il est possible de réaliser en une seule étape des canaux à la fois longs et fins dans des échantillons y compris en matériau semi-conducteur, avec des moyens optiques de dimensions acceptables de façon industrielle. La première impulsion laser pourra fixer la longueur et la position du canal à percer tandis que la densité d'énergie de la deuxième impulsion (ou du train d'impulsions subséquent à la première impulsion lumineuse) pourra fixer le diamètre du canal. En ce qui concerne le domaine de la soudure (« wafer bonding »), la densité d'énergie de la deuxième impulsion pourra permettre d'ajuster la température locale pour la fusion du matériau. Les paramètres de durée et d'énergie de chaque impulsion sont déterminés de façon à minimiser les effets non linéaire délétères mais aussi de façon à conserver les propriétés de localisation de dépôt d'énergie dans le matériau. En effet, l'excitation avec une impulsion ultra brève permet de créer plus de charges libres par ionisation multi photonique que par des ionisations amorcées par les défauts du milieu, et de mieux contrôler ainsi la forme du canal plasma.

La figure 2 illustre selon un exemple de réalisation un dispositif 1 de nano-usinage selon l'invention.

Le dispositif 1 comprend une source laser 201 et un module de mise en forme temporelle 202 permettant de générer par exemple une première et une seconde impulsions lumineuses, notées respectivement I₁ et I₂, dont des exemples de réalisation seront détaillés par la suite. Le dispositif comprend en outre un module de focalisation 203 pour la mise en forme spatiale des impulsions dans l'échantillon, permettant de générer à partir d'un faisceau incident donné un faisceau non diffractant 210 dans l'échantillon selon une ligne de focalisation. Le faisceau non diffractant est par exemple de type Bessel ou Airy. La ligne de focalisation est généralement orientée selon un axe optique du module de focalisation. Dans cet exemple, les deux impulsions lumineuses I₁ et I₂ traversent le même module 203, ce qui permet de faciliter la superposition spatiale des impulsions dans l'échantillon. Alternativement, seule la première impulsion lumineuse est mise en forme spatialement par le module de focalisation 203.

Le module de focalisation 203 permettant de générer un faisceau non diffractant peut être de type « direct » comme cela est représenté sur la figure 2, par exemple pour la génération d'un faisceau de type faisceau de Bessel. Il comprend dans cet exemple un système optique 212 apte à générer un faisceau non diffractant puis un système imageur pour la réduction de la taille du faisceau dans l'échantillon. Le système optique 212 peut comprendre pour la génération d'un faisceau de Bessel, de façon connue, une lentille de type axicon, un miroir de type axicon, une matrice de micro-miroirs (MEMS), un modulateur de phase spatiale par réflexion ou transmission ou d'une manière générale, tout système optique permettant d'appliquer une modulation de phase linéaire avec symétrie de rotation. Le système imageur est par exemple un système de type "télescopique" ou "4f", afin de ne pas introduire de distorsion de phase quadratique, comprenant une optique 204 et un objectif de microscope 209. Dans l'exemple de la figure 2, l'objectif de microscope 209 permet de fortement réduire la taille des faisceaux dans l'échantillon. Avantageusement, l'objectif de microscope permet aussi de former une image de l'échantillon à usiner sur une caméra 206 devant laquelle un objectif de focalisation 207 est agencé afin de repérer la zone de l'échantillon que l'on veut usiner et assurer le positionnement vis-à-vis du faisceau. Dans l'exemple de la figure 2, un filtre spatial 211 positionné dans le plan focal de l'optique 204 permet le filtrage spatial des figures de diffraction formées par le système optique 212 pour ne sélectionner que les fréquences spatiales correspondant au faisceau non diffractant d'intérêt, par exemple le faisceau de Bessel d'ordre 0.

Alternativement, dans le cas de la génération d'un faisceau d'Airy par exemple, le module de focalisation 203 est de type « indirect », la mise en forme spatiale du faisceau incident étant réalisée dans le plan de Fourier d'une lentille (pour la génération d'un faisceau d'Airy, voir par exemple P. Polynkin et al., "Curved Plasma Channel Generation Using Ultraintense Airy Beams," Science 324, 229-232 (2009)). Un système imageur 204, 209, comme celui décrit sur la figure 2 permet la réduction du faisceau d'Airy depuis le plan focal image de la lentille réalisant la transformée de Fourier.

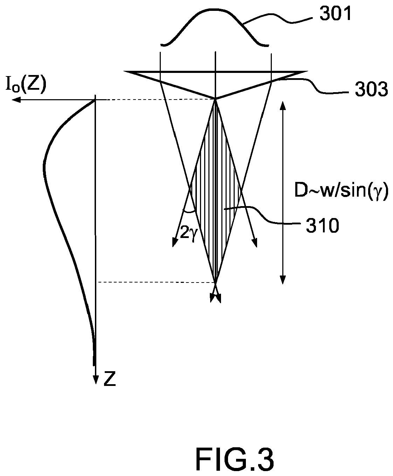

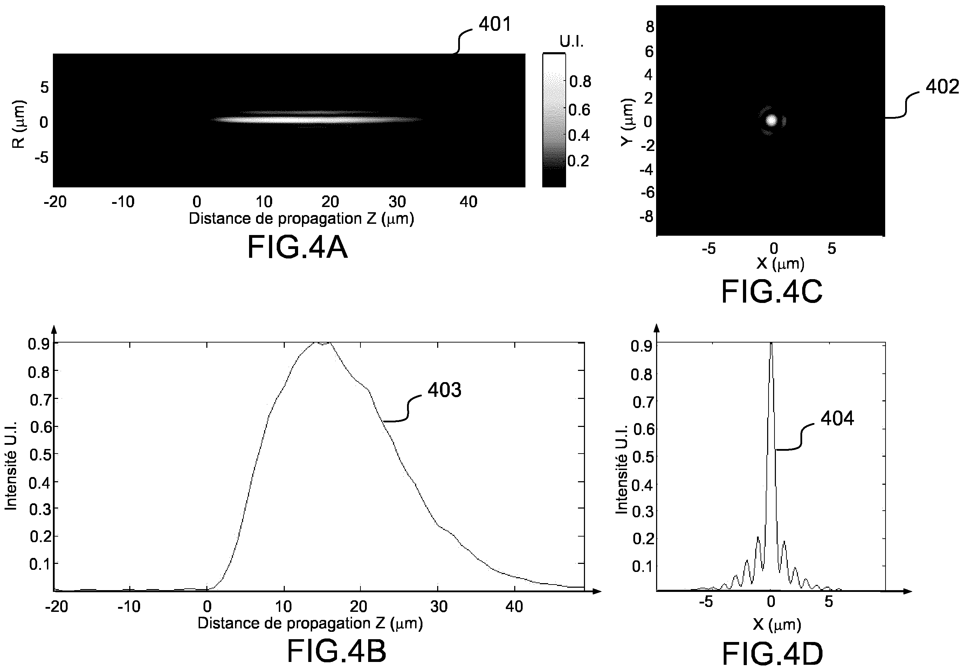

Les figures 3 et 4 illustrent par des schémas et des images expérimentales ou obtenues par simulation le faisceau non diffractant obtenu avec des moyens de mise en forme spatiale adaptés à la formation d'un faisceau non diffractant de type Bessel.

Le module de focalisation pour la mise en forme spatiale est schématisé sur la figure 3 par un système optique 303 de type axicon. Dans cet exemple, le faisceau incident 301 présente une répartition spatiale de type gaussien. De façon connue, il se forme une ligne de focalisation 310 dont la répartition d'intensité lumineuse I₀(z) suit une fonction de Bessel d'ordre 0. La longueur D de la ligne de focalisation est proportionnelle au rapport de la largeur du faisceau w du faisceau gaussien incident 301 sur le système optique 303 par le sinus de l'angle conique y défini par la structure de l'axicon 303.

Les figures 4A à 4D représentent des images et des profils spatiaux de l'intensité lumineuse de faisceaux de Bessel mesurés dans l'air, selon un profil longitudinal (4A, 4B) et un profil transverse (4C, 4D). On observe sur la figure 4A (image 401) une propagation avec un profil constant sur une distance de près de 20 µm avec un diamètre de la tache de focalisation (image 402, figure 4C) inférieure à 1 µm. La courbe 403 (figure 4B) illustrant le profil spatial de l'intensité de l'image 401 montre la répartition inhomogène de l'intensité lumineuse sur l'axe z de propagation. Cette inhomogénéité, visible sur la courbe d'intensité I₀(z) de la figure 3 est liée à la répartition spatiale gaussienne du faisceau incident.

Selon une variante, la mise en forme spatiale peut comprendre la modulation d'amplitude permettant d'ajuster l'intensité des faisceaux sur l'axe de propagation, en particulier pour la rendre la plus uniforme possible. Cette modulation d'amplitude peut être réalisée soit par un système de modulation spécifique du module de focalisation, par exemple une matrice de miroirs ou un modulateur de phase, ou il peut être intégré au système de modulation existant lorsqu'un tel système de modulation est déjà utilisé pour former le faisceau non diffractant. Dans ce cas, une partie de l'énergie peut être déviée vers un ordre de diffraction qui sera filtré spatialement, par exemple au moyen du filtre spatial 211 décrit sur la figure 2.

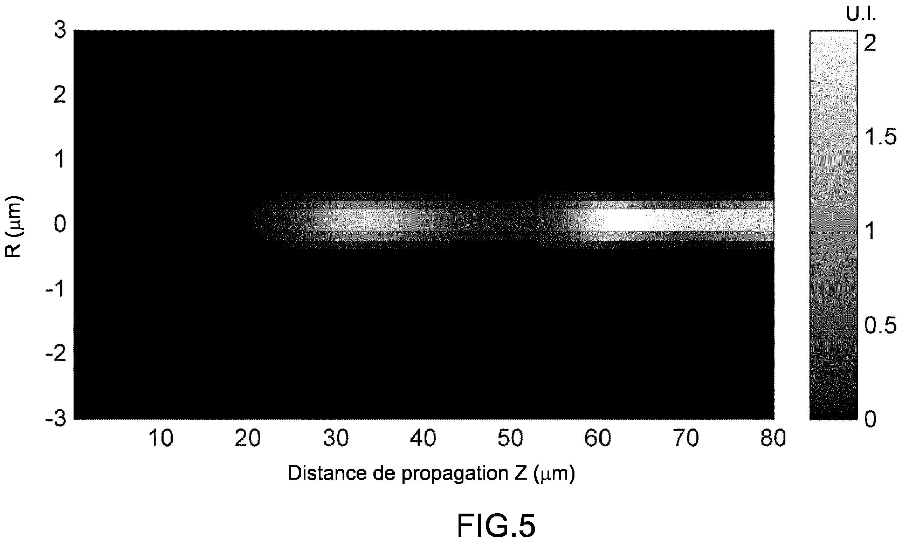

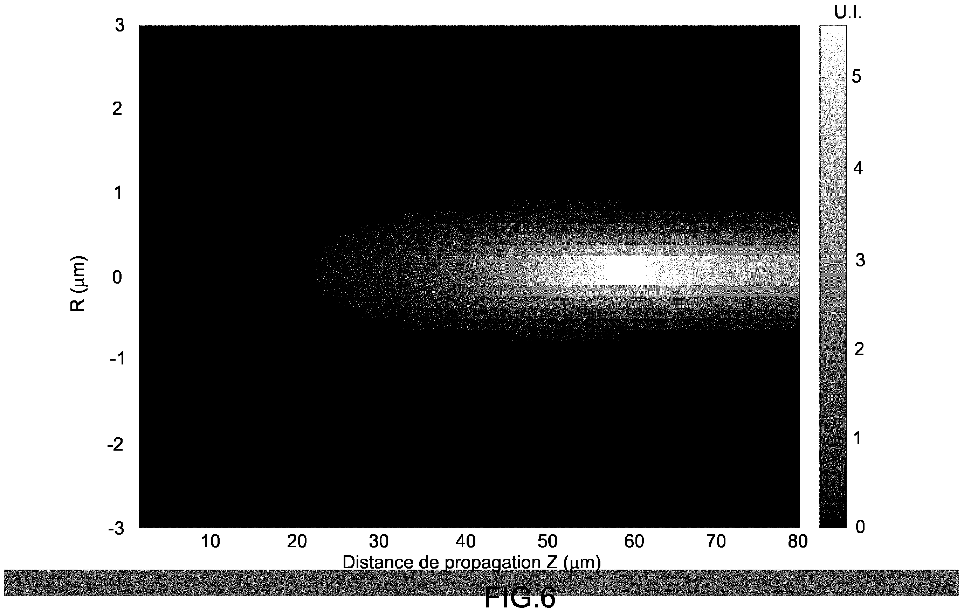

La figure 5 présente une simulation numérique correspondant à la génération de plasma par une impulsion ultra brève dont la structure spatiale est de Bessel, dans un milieu à faible gap (diélectrique ou semi-conducteur), en présence de non-linéarité Kerr. Il apparait sur la figure 5 que pour des fortes intensités, la densité de charges créée (« canal plasma ») subit de fortes variations selon l'axe de propagation, ceci étant plus particulièrement le cas lorsque la ligne de focalisation traverse une interface (air - verre par exemple). En conséquence, le dépôt d'énergie est particulièrement inhomogène. La figure 6 présente la même distribution spatiale de plasma générée par une séquence de plusieurs impulsions, la première impulsion ultra brève mais de faible énergie permettant de générer le canal plasma tandis que la seconde impulsion ou le train d'impulsions subséquent permettant de déposer l'énergie pour l'échauffement du matériau en vue de l'ablation ou de la soudure par exemple. L'énergie lumineuse totale est comparable à la précédente dans les deux cas, mais dans le cas de la figure 6, la distribution de plasma présente moins de variations, et le dépôt d'énergie est nettement plus homogène.

Grâce à la méthode décrit ci-dessus, les canaux peuvent atteindre des diamètres de l'ordre de 10 nanomètres à quelques micromètres, avec des rapports de forme contrôlables, dans la gamme de 1 à 500. Dans le cas de la soudure, les faisceaux non-diffractant permettent de façon naturelle de réduire fortement la contrainte sur le positionnement du faisceau vis-à-vis de l'interface, puisque la zone focale des faisceaux non-diffractant peut être très longue.

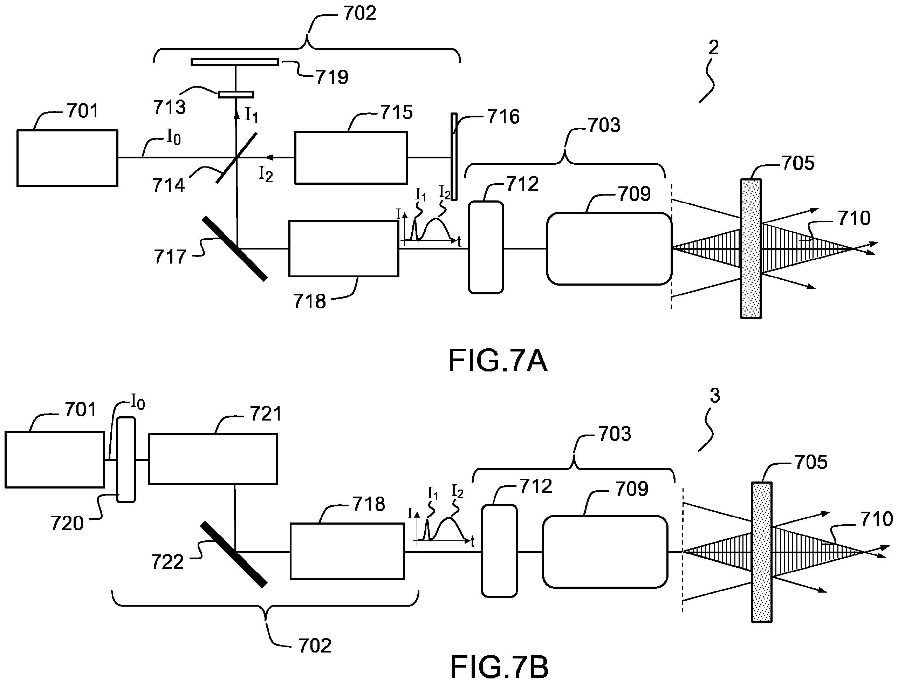

Les figures 7A, 7B illustrent deux exemples de mise en oeuvre d'un module de mise en forme temporelle dans des exemples 2 et 3 de dispositif de nano-usinage selon l'invention.

Chacun des dispositifs 2 et 3 comprend une source laser 701 et un module de mise en forme temporelle 702 permettant de générer lesdites première et seconde impulsions lumineuses I₁ et I₂. Le dispositif comprend en outre un module de focalisation 703 pour la mise en forme spatiale du faisceau permettant de générer à partir d'un faisceau incident donné un faisceau non diffractant 710, par exemple de type Bessel ou Airy, comme il a été décrit précédemment. Par exemple, le module de focalisation comprend un système optique 712 apte à générer le faisceau non diffractant et un bloc optique 709 comprenant un télescope pour la réduction de faisceau et un ensemble de miroirs pour la déflexion et le balayage. Dans les exemples des figures 7A et 7B, un module de conversion de fréquence 718 permet d'adapter la longueur d'onde des impulsions à la bande de transparence du matériau à usiner. Pour le cas du silicium par exemple, une longueur d'onde de 1550 nm sera choisie de préférence. Un faisceau ultra-bref à cette longueur d'onde peut être obtenu par exemple grâce à un laser 701 centré à 800 nm (par exemple par technologie Titane:Saphir) ou 1030 nm à 1064 nm (par exemple par technologie Ytterbium) en technologie fibrée ou non, injecté dans le système de conversion de fréquence 718, ce dernier pouvant être un amplificateur paramétrique optique (OPA) ou un oscillateur paramétrique optique (OPO). Le module de conversion de fréquence peut être agencé en aval du module de mise en forme temporelle 702, la mise en forme temporelle pouvant être plus facilement réalisée à des longueurs d'onde plus courtes.

La figure 7A illustre un premier exemple de module 702 de mise en forme temporelle. Dans cet exemple, une impulsion I₀ émise par la source laser 701 est divisée en deux au moyen d'une lame séparatrice 714. Une première impulsion I₁ est réfléchie par un miroir 719 puis envoyée sur le module de conversion de fréquence 718 au moyen d'une lame de déflexion 717. Un atténuateur 713 permet d'adapter l'intensité lumineuse de l'impulsion I₁ en fonction de la nature de l'échantillon 705 que l'on cherche à usiner. Une deuxième impulsion est étirée temporellement par des moyens 715 connus de l'état de l'art des technologies femtoseconde, par exemple un système à réseaux, à prisme ou un cristal acousto-optique pour former l'impulsion I₂. Cette impulsion est ensuite dirigée vers le module de conversion de fréquence 718 de la même manière.

La figure 7B illustre un second exemple de module 702 de mise en forme temporelle. Dans cet exemple, l'impulsion I₀ est divisée en deux impulsions et étirée temporellement grâce à un système acousto-optique 721 de type DAZZLER® (entreprise FASTLITE®). Un obturateur 720 commandé électroniquement permet de sélectionner une impulsion parmi un train d'impulsions, lorsqu'on travaille avec des sources laser à forte cadence par exemple.

Alternativement aux dispositifs 2 et 3 représentés sur les figures 7A et 7B, deux sources laser synchronisées distinctes peuvent être utilisées. La première source laser peut permettre alors l'émission d'une première impulsion ultra brève comme décrit ci-dessus. La deuxième source laser peut permettre l'émission d'une deuxième impulsion dont la durée est choisie par exemple en fonction du diamètre des canaux à percer, par exemple entre 1 picoseconde et quelques millisecondes. Les deux impulsions présentent des bandes spectrales comprises dans la bande de transparence du matériau à usiner. Dans ce cas, il n'est pas nécessaire d'utiliser un moyen d'étirement temporel du faisceau.

Selon une variante, la durée et l'énergie de la deuxième impulsion sont ajustées de sorte à ne produire aucun effet si la deuxième impulsion est appliquée seule dans le matériau. Dans ce cas, la synchronisation des impulsions est un paramètre plus flexible. La deuxième impulsion peut être envoyée avant la première impulsion. L'énergie déposée dans le matériau est alors proportionnelle à la différence temporelle entre la fin de la deuxième impulsion et le début de la première impulsion. En particulier, cette approche permet de réduire les contraintes sur la précision de la synchronisation lorsque la durée de la deuxième impulsion est grande devant celle de la première impulsion.

Selon une variante, le dispositif de nano-usinage selon l'invention comprend un obturateur commandé électroniquement permettant de sélectionner une ou plusieurs impulsions parmi le train d'impulsion émis par le(s) laser(s). L'obturateur peut être mécanique ou optique. Dans ce dernier cas, il s'agit par exemple d'une cellule de pockels suivie d'un polariseur.

Alternativement, la mise en forme temporelle comprend la génération d'un train d'impulsions, la première des impulsions, ultra brève, permettant la génération dans l'échantillon du plasma de charges libres au niveau de la ligne de focalisation obtenu par absorption multi-photonique grâce au module de focalisation et les impulsions subséquentes permettant le dépôt de l'énergie. La durée de la première impulsion est par exemple inférieure à 10 ps. Les secondes impulsions peuvent être plus ou moins courtes mais de faible intensité chacune. Ainsi, il est possible d'utiliser un train de secondes impulsions ultra brèves pour le dépôt de l'énergie et la génération de l'échauffement du matériau par absorption par les charges libres du plasma, typiquement de durée inférieure à 10 ps, par exemple de durée inférieure à la durée de vie du plasma de charges libres dans le matériau (soit environ 100 fs dans le verre). Les impulsions sont resserrées temporellement, par exemple l'écart temporel entre les impulsions est inférieur à 10 ps. L'intensité desdites impulsions est suffisamment faible pour éviter la déstabilisation de faisceau par effet non linéaire de type Kerr. Par contre, l'intensité peut être suffisante pour contribuer à la génération de charges libres et amplifier la densité de plasma. a génération d'un train d'impulsions peut être obtenue par les moyens décrits en référence aux figures 7A, 7B, notamment avec un DAZZLER®, ou plusieurs lignes à retard. Alternativement, il est également possible d'imprimer spectralement, par exemple au moyen d'un DAZZLER®, une phase du troisième ordre, ce qui donne temporellement un faisceau de type Airy, avec de multiple rebonds.

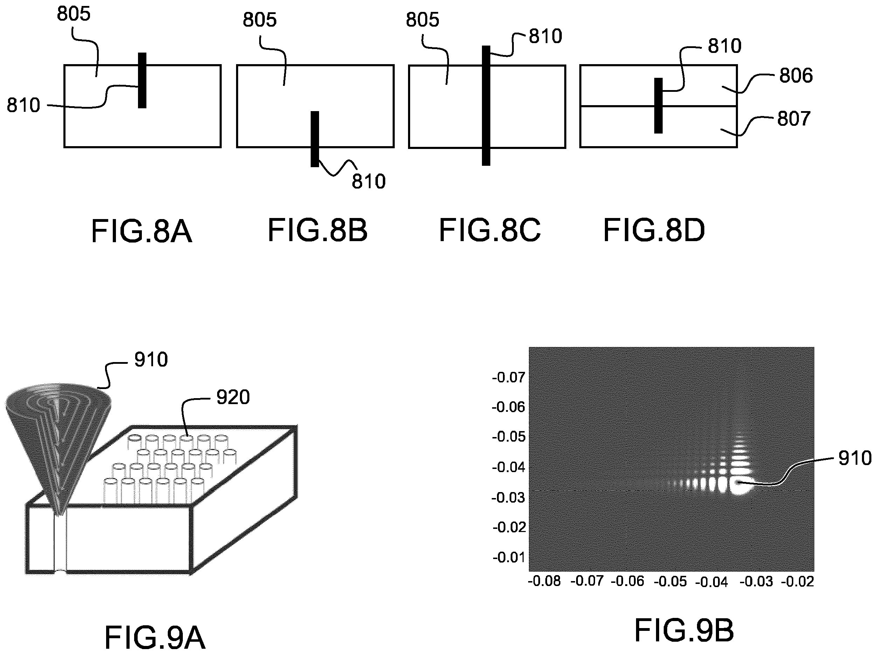

Les figures 8A à 8D illustrent différentes applications de la méthode de nano-usinage selon l'invention. Sur ces figures, le canal plasma est représenté par le segment 810. Les figures 8A et 8B montrent une ablation respectivement en face avant et en face arrière d'un échantillon 805 en matériau semi-conducteur. La figure 8C montre une ablation traversante et la figure 8D montre une soudure entre deux échantillons 806 et 807.

Selon une variante, pour le perçage séquentiel de plusieurs canaux dans l'échantillon, il est possible d'effectuer un mouvement relatif entre le faisceau et l'échantillon. Ceci peut être réalisé soit en déplaçant le faisceau seul via une technique de balayage de faisceau ou en déplaçant l'échantillon par des platines de translation et rotation sur les différents axes de l'espace ou les deux conjointement. Pour l'application à la soudure, il est possible de synchroniser électroniquement ou via un ordinateur les déplacements relatifs et l'obturateur. Le déplacement relatif entre le faisceau et l'échantillon permet notamment de fixer la zone d'ablation ou de soudure (810, figures 8A à 8D). Pour l'ablation, on positionne le faisceau de telle sorte qu'il croise une surface (avant ou arrière) pour l'éjection du matériau. La profondeur du faisceau dans la matière fixe la position longitudinale de la zone d'ablation.

Selon une variante, pour réaliser des usinages en parallèle, il est également possible de générer plusieurs faisceaux en parallèle, en utilisant par exemple des matrices de systèmes optiques pour la formation de faisceaux non-diffractant, ou en utilisant un modulateur de phase spatiale ou un hologramme permettant de produite plusieurs faisceaux non diffractant en parallèle.

Les figures 9A et 9B illustrent une variante de la méthode selon l'invention dans laquelle des faisceaux non-diffractant de type Airy sont générés par le module de focalisation. Lors du perçage séquentiel de nano-canaux par un faisceau de Bessel, dans le cas où les canaux sont suffisamment rapprochés les uns des autres, il est possible que la lumière laser doive traverser la zone où des canaux ont déjà été percés précédemment avant d'atteindre la ligne d'ablation. Dans ce cas, une partie de la lumière est diffusée et le faisceau peut être partiellement déformé. L'avantage dans ce cas d'utiliser un faisceau 910 de type Airy comme celui décrit sur la figure 9B, réside dans le fait que l'intensité du laser est contenue uniquement dans un seul quadrant du plan. Ainsi, il est possible de percer les canaux (920, figure 9A) avec le lobe principal du faisceau d'Airy en s'arrangeant pour que le cadran occupé par la lumière ne superpose jamais la zone où des canaux ont précédemment été percés.

Bien que décrite à travers un certain nombre d'exemples de réalisation détaillés, le procédé et le dispositif de nano-usinage par laser selon l'invention comprennent différentes variantes, modifications et perfectionnements qui apparaîtront de façon évidente à l'homme de l'art, étant entendu que ces différentes variantes, modifications et perfectionnements font partie de la portée de l'invention, telle que définie par les revendications qui suivent.

## Revendications

1. Dispositif de nano-usinage par laser destiné au nano-usinage d'un échantillon (705) en matériau présentant une bande de transparence donnée, définie par le domaine spectral dans lequel le coefficient d'absorption du matériau est inférieur à 0,5 cm⁻¹, le dispositif comprenant :
- un module de focalisation (203, 703) permettant de générer à partir d'un faisceau incident donné un faisceau non diffractant selon une ligne de focalisation généralement orientée selon l'axe optique du module de focalisation;
et **caractérisé par** :
- des premiers moyens d'émission (202, 701-702) d'une première impulsion lumineuse (I₁) de bande spectrale comprise dans la bande de transparence dudit matériau, apte à générer dans ledit matériau, après focalisation par ledit module de focalisation, un plasma de charges libres au niveau de ladite ligne de focalisation par absorption multi-photonique formant ainsi un « canal plasma »;
- des seconds moyens d'émission (202, 701-702) d'au moins une seconde onde électromagnétique de bande spectrale comprise dans la bande de transparence dudit matériau, d'intensité lumineuse inférieure à l'intensité lumineuse de la première impulsion lumineuse, destinée à être superposée spatialement audit canal plasma pour générer un échauffement dudit matériau par absorption par les charges libres du plasma.

2. Dispositif selon la revendication 1, dans lequel ladite première impulsion lumineuse présente une durée inférieure à 10 picosecondes.

3. Dispositif selon l'une quelconque des revendications précédentes, dans lequel lesdits seconds moyens d'émission permettent l'émission d'une impulsion lumineuse de durée comprise entre quelques fractions de picosecondes et quelques millisecondes.

4. Dispositif selon la revendication 3, dans lequel lesdits seconds moyens d'émission permettent l'émission d'un train d'impulsions lumineuses.

5. Dispositif selon l'une quelconque des revendications précédentes, dans lequel lesdits premier et second moyens d'émission sont formés par deux sources laser distinctes synchronisées.

6. Dispositif selon l'une quelconque des revendications précédentes 1 à 4, dans lequel lesdits premier et second moyens d'émission sont formés par une source d'émission d'une impulsion laser unique (701) et un module de mise en forme temporelle (702) permettant de générer à partir de l'onde lumineuse émise par ladite source laser une première et au moins une seconde impulsions lumineuses.

7. Dispositif selon la revendication 6, dans lequel ledit module de mise en forme temporelle comprend un séparateur de faisceaux (714) permettant de former au moins deux voies, et sur au moins l'une des voies, un étireur d'impulsion (715).

8. Dispositif selon la revendication 6, dans lequel ledit module de mise en forme temporelle comprend un système acousto-optique (721) de type DAZZLER®.

9. Dispositif selon l'une quelconque des revendications 6 à 8, comprenant en outre un module de conversion de fréquence (718) en aval dudit module de mise en forme temporelle.

10. Dispositif selon l'une quelconque des revendications précédentes, dans lequel le module de focalisation permet de générer un faisceau de Bessel.

11. Dispositif selon l'une quelconque des revendications 1 à 9, dans lequel le module de focalisation permet de générer un faisceau d'Airy.

12. Dispositif selon l'une quelconque des revendications précédentes, dans lequel ledit module de focalisation permet la formation d'une matrice de faisceaux non diffractant.

13. Méthode de nano-usinage laser d'un échantillon (105) en matériau présentant une bande de transparence donnée, définie par le domaine spectral dans lequel le coefficient d'absorption du matériau est inférieur à 0,5 cm⁻¹, la méthode comprenant :
- l'émission d'une première impulsion de bande spectrale comprise dans la bande de transparence dudit matériau;
et étant **caractérisée par** :
- la mise en forme spatiale de ladite première impulsion permettant de former après focalisation dans ledit échantillon un faisceau non diffractant selon une ligne de focalisation, l'intensité lumineuse dudit faisceau non diffractant permettant de générer un plasma de charges libres au niveau de ladite ligne de focalisation par absorption multi-photonique, formant ainsi un « canal plasma »;
- l'émission d'au moins une seconde onde électromagnétique de bande spectrale comprise dans la bande de transparence dudit matériau, d'intensité lumineuse inférieure à l'intensité lumineuse de la première impulsion lumineuse, et superposée spatialement audit canal plasma pour générer un échauffement dudit matériau par absorption par les charges libres du plasma.

14. Méthode selon la revendication 13, dans laquelle la mise en forme spatiale de ladite première impulsion comprend en outre une modulation spatiale de l'amplitude de ladite impulsion afin de rendre l'intensité lumineuse de ladite première impulsion sensiblement constante sur ladite ligne de focalisation.

15. Méthode selon l'une quelconque des revendications 13 à 14 appliquée au nano-perçage d'un échantillon en matériau donné pour la formation d'un canal, comprenant :
- le contrôle de la position et de la longueur du canal à percer par la mise en forme spatiale et l'intensité lumineuse de ladite première impulsion lumineuse et
- le contrôle du diamètre du canal par l'énergie déposée par la ou lesdite(s) seconde(s) onde(s) électromagnétique(s) au niveau du canal plasma ainsi formé.

16. Méthode selon l'une quelconque des revendications 13 à 15, dans lequel l'échantillon est en matériau semi-conducteur.

## Patentansprüche

1. Vorrichtung zur nanoskaligen Laserbearbeitung für die nanoskaligen Bearbeitung einer Probe (705) aus einem Material mit einem Band mit vorgegebener Transparenz, welches durch den Spektralbereich definiert ist, in dem der Absorptionskoeffizient des Materials kleiner ist als 0,5 cm⁻¹, wobei die Vorrichtung Folgendes umfasst:
- ein Fokussiermodul (203, 703), mit dem sich aus einem vorgegebenen einfallenden Strahl ein nicht beugender Strahl gemäß einer Fokussierlinie erzeugen lässt, die im Allgemeinen gemäß der optischen Achse des Fokussiermoduls ausgerichtet ist,
und durch Folgendes gekennzeichnet:
- erste Mittel (202, 701-702) zum Senden eines ersten Lichtimpulses (I₁) mit einem Spektralband, das in dem Transparenzband des Materials enthalten ist und geeignet ist, in dem Material nach Fokussierung durch das Fokussiermodul ein Plasma aus freien Ladungen an der Fokussierlinie durch multiphotonische Absorption erzeugen kann, wodurch ein "Plasmakanal" gebildet wird,
- zweite Mittel (202, 701-702) zum Senden mindestens einer zweiten elektromagnetischen Welle mit einem Spektralband, das in dem Transparenzband des Materials enthalten ist und die zweite elektromagnetische Welle eine Lichtstärke aufweist, die geringer ist als die Lichtstärke des ersten Lichtimpulses, und die dazu bestimmt ist, räumlich über dem Plasmakanal angeordnet zu werden, um eine Erhitzung des Materials durch Absorption durch die freien Plasmaladungen zu erzeugen.

2. Vorrichtung nach Anspruch 1, bei der der erste Lichtimpuls eine Dauer von weniger als 10 Pikosekunden aufweist.

3. Vorrichtung nach einem beliebigen der vorhergehenden Ansprüche, bei der die zweiten Sendemittel das Aussenden eines Lichtimpulses mit einer Dauer zwischen einigen Pikosekundenbruchteilen und einigen Millisekunden ermöglichen.

4. Vorrichtung nach Anspruch 3, bei der die zweiten Sendemittel das Aussenden einer Lichtimpulsfolge ermöglichen.

5. Vorrichtung nach einem beliebigen der vorhergehenden Ansprüche, bei der die ersten und zweiten Sendemittel durch zwei synchronisierte separate Laserquellen gebildet sind.

6. Vorrichtung nach einem beliebigen der vorhergehenden Ansprüche 1 bis 4, bei der die ersten und zweiten Sendemittel durch eine einzige Quelle (701) zum Aussenden eines Laserimpulses und ein Modul (702) zur zeitlichen Formung gebildet sind, welches ausgehend von der von der Laserquelle ausgesendeten Lichtwelle das Erzeugen eines ersten und mindestens eines zweiten Lichtimpulses ermöglicht.

7. Vorrichtung nach Anspruch 6, bei der das Modul zur zeitlichen Formung einen Strahlenteiler (714), der die Bildung von mindesten zwei Wege ermöglicht, sowie einen Impulsstrecker (715) auf mindestens einem der Wege umfasst.

8. Vorrichtung nach Anspruch 6, bei der das Modul zur zeitlichen Formung ein akustisch-optisches System (721) des Typs DAZZLER® umfasst.

9. Vorrichtung nach einem beliebigen der Ansprüche 6 bis 8, umfassend ferner ein Modul (718) zur Frequenzumwandlung nach dem Modul zur zeitlichen Formung.

10. Vorrichtung nach einem beliebigen der vorhergehenden Ansprüche, bei der das Fokussierungsmodul die Erzeugung eines Bessel-Strahls ermöglicht.

11. Vorrichtung nach einem beliebigen der Ansprüche 1 bis 9, bei der das Fokussierungsmodul die Erzeugung eines Airy-Strahls ermöglicht.

12. Vorrichtung nach einem beliebigen der vorhergehenden Ansprüche, bei der das Fokussierungsmodul die Bildung einer Matrix nicht beugender Strahlen ermöglicht.

13. Verfahren zur nanoskaligen Laserbearbeitung einer Probe (105) aus einem Material mit einem Band mit vorgegebener Transparenz, welches durch den Spektralbereich definiert ist, in dem der Absorptionskoeffizient des Materials kleiner ist als 0,5 cm⁻¹, wobei das Verfahren Folgendes umfasst:
- Senden eines ersten Impulses mit einem Spektralband, das in dem Transparenzband des Materials enthalten ist,
durch Folgendes gekennzeichnet:
- die räumliche Formung des ersten Impulses, die nach Fokussierung in der Probe die Bildung eines nicht beugenden Strahls gemäß einer Fokussierlinie ermöglicht, wobei die Lichtstärke des nicht beugenden Strahls die Erzeugung eines Plasmas aus freien Ladungen an der Fokussierlinie durch multiphotonische Absorption ermöglicht, wodurch ein "Plasmakanal" gebildet wird,
- Senden mindestens einer zweiten elektromagnetischen Welle mit einem Spektralband, das in dem Transparenzband des Materials enthalten ist und eine Lichtstärke aufweist, die geringer ist als die Lichtstärke des ersten Lichtimpulses, und das räumlich über dem Plasmakanal angeordnet ist, um eine Erhitzung des Materials durch Absorption durch die freien Plasmaladungen zu erzeugen.

14. Verfahren nach Anspruch 13, bei dem die räumliche Formung des ersten Impulses ferner eine räumliche Modulation der Amplitude des Impulses umfasst, um die Lichtstärke des erste Impulses im Wesentlichen konstant auf der Fokussierungslinie zu machen.

15. Verfahren nach einem beliebigen der Ansprüche 13 bis 14 zur Nanobohrung einer Probe aus einem gegebenen Material zur Bildung eines Kanals, umfassend:
- die Kontrolle der Position und der Länge des zu bohrenden Kanals durch die räumliche Formung und die Lichtstärke des ersten Lichtimpulses und
- die Kontrolle des Kanaldurchmessers durch die von der oder den zweiten elektromagnetischen Welle(n) an dem derart gebildeten Plasmakanal abgegebene Energie.

16. Verfahren nach einem beliebigen der Ansprüche 13 bis 15, bei dem die Probe aus einem halbleitenden Material besteht.

## Claims

1. A device for laser nanomachining a sample (705) made of a material having a given transparency band, said transparency band being defined as the spectral domain in which the absorption coefficient of the material is lower than 0.5 cm⁻¹, the device comprising:
- a focusing module (203, 703) allowing, from a given incident beam, a non-diffracting beam to be generated along a focal line generally oriented along the optical axis of the focusing module;
and being **characterized by** further comprising:
- first means (202, 701-702) for emitting a first light pulse (I₁) in a spectral band comprised in the transparency band of said material, able to generate in said material, after focusing by said focusing module, a plasma of free carriers along said focal line via multi-photon absorption, thus forming a "plasma channel"; and
- second means (202, 701-702) for emitting at least one second electromagnetic wave in a spectral band comprised in the transparency band of said material, intended to be spatially superposed on said plasma channel in order to heat said material via absorption by the free carriers of the plasma.

2. The device as claimed in claim 1, in which said first light pulse has a duration shorter than 10 picoseconds.

3. The device as claimed in any one of the preceding claims, in which said second emitting means allow a light pulse of duration ranging between a few fractions of a picosecond and a few milliseconds to be emitted.

4. The device as claimed in claim 3, in which said second emitting means allow a train of light pulses to be emitted.

5. The device as claimed in any one of the preceding claims, in which said first and second emitting means are formed by two separate synchronized laser sources.

6. The device as claimed in any one of preceding claims 1 to 4, in which said first and second emitting means are formed by a source emitting a single laser pulse (701) and a temporal shaping module (702), allowing a first and at least one second light pulses to be generated from the light wave emitted by said laser source.

7. The device as claimed in claim 6, in which said temporal shaping module comprises a beam splitter (714) allowing at least two channels to be formed, and, in at least one of the channels, a pulse stretcher (715).

8. The device as claimed in claim 6, in which said temporal shaping module comprises an acousto-optic system (721) of the DAZZLER® type.

9. The device as claimed in any one of claims 6 to 8, furthermore comprising a frequency converting module (718) downstream of said temporal shaping module.

10. The device as claimed in any one of the preceding claims, in which the focusing module allows a Bessel beam to be generated.

11. The device as claimed in any one of claims 1 to 9, in which the focusing module allows an Airy beam to be generated.

12. The device as claimed in any one of the preceding claims, in which said focusing module allows a matrix of non-diffracting beams to be formed.

13. A method for laser nanomachining a sample (105) made of a material having a given transparency band, said transparency band being defined as the spectral domain in which the absorption coefficient of the material is lower than 0.5 cm⁻¹, the method comprising:
- emitting a first pulse in a spectral band comprised in the transparency band of said material;
and being **characterized by** further comprising:
- spatial shaping of said first pulse, allowing, after focusing in said sample, a non-diffracting beam to be formed along a focal line, the light intensity of said non-diffracting beam allowing a plasma of free carriers to be generated along said focal line via multi-photon absorption, thus forming a "plasma channel"; and
- emitting at least one second electromagnetic wave in a spectral band comprised in the transparency band of said material, spatially superposed on said plasma channel in order to heat said material via absorption by the free carriers of the plasma.

14. The method as claimed in claim 13, in which the spatial shaping of said first pulse furthermore comprises spatial modulation of the amplitude of said pulse in order to make the light intensity of said first pulse substantially constant over said focal line.

15. The method as claimed in either one of claims 13 and 14, applied to nano-drilling of a sample made of a given material in order to form a channel, comprising:
- controlling the position and the length of the channel to be drilled via the spatial shaping and light intensity of said first light pulse; and
- controlling the diameter of the channel via the energy deposited by said second electromagnetic wave(s) in the plasma channel thus formed.

16. The method as claimed in any one of claims 13 to 15, in which the sample is made of a semiconductor.
